(19) **Europäisches Patentamt / European Patent Office / Office européen des brevets**

(11) **EP 1 815 260 B1**

(12) **FASCICULE DE BREVET EUROPEEN**

(45) Date de publication et mention de la délivrance du brevet:
**19.03.2008 Bulletin 2008/12**

(21) Numéro de dépôt: **05807401.4**

(22) Date de dépôt: **28.09.2005**

(51) Int Cl.:
*G01R 31/12* (2006.01)      *G01R 31/02* (2006.01)

(86) Numéro de dépôt international:
**PCT/FR2005/002394**

(87) Numéro de publication internationale:
**WO 2006/037874 (13.04.2006 Gazette 2006/15)**

(54) **PROCÉDÉ ET DISPOSITIF DE DÉTECTION D'UN PHÉNOMÈNE D'ARC ÉLECTRIQUE SUR AU MOINS UN CÂBLE ÉLECTRIQUE**

VERFAHREN UND EINRICHTUNG ZUR ERKENNUNG DES ELEKTRISCHEN BOGENPHÄNOMENS AUF MINDESTENS EINEM ELEKTRISCHEN KABEL

METHOD AND DEVICE FOR DETECTING ELECTRIC ARC PHENOMENON ON AT LEAST ONE ELECTRIC CABLE

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **01.10.2004 FR 0410384**

(43) Date de publication de la demande:
**08.08.2007 Bulletin 2007/32**

(73) Titulaire: **AIRBUS France**
**31060 Toulouse (FR)**

(72) Inventeurs:
- **DUTOYA, Michel,**
  **Résidence Domaine Saint-Martin**
  **F-31300 Toulouse (FR)**
- **MAZEAU, Gilles**
  **F-31700 Blagnac (FR)**
- **VLACICH, Christophe**
  **F-31200 Toulouse (FR)**

(74) Mandataire: **Hauer, Bernard**
**Cabinet Bonnétat**
**29, Rue de Saint-Pétersbourg**
**75008 Paris (FR)**

(56) Documents cités:
**EP-A- 0 537 066**          **WO-A-96/12969**
**DE-A- 19 640 340**        **US-A1- 2004 156 153**
**US-B1- 6 772 077**

- **ANONYMOUS: "Algorithms - Discriminant Analysis, Mahalanobis Distance" INTERNET ARTICLE, [Online] XP002328676 Extrait de l'Internet: URL:http://www.thermo.com/com/cda/resource s/resources_detail/ 1,2166,13324,00.html?fr omPage=search&keyword=mahalanobis> [extrait le 2005-05-18]**

**Description**

La présente invention concerne un procédé et un dispositif de détection d'un phénomène d'arc électrique sur un câble électrique, faisant partie par exemple d'un faisceau de câbles électriques.

On sait qu'un phénomène d'arc électrique est le résultat de l'apparition d'une lente dégradation des gaines isolantes des câbles utilisés pour la distribution d'énergie électrique, alternative ou continue, causée par un environnement agressif (humidité dans l'air, moisissures, frottements, vibrations des cosses de raccordement, températures variées, cisaillements, ...).

Le phénomène d'arc électrique se décompose en quatre phases successives d'énergie croissante:

- une phase d'effluves correspondant à la naissance du phénomène;
- une phase de conduction mono-alternance correspondant à une rupture diélectrique, avec une augmentation de l'intensité;
- une phase de conduction double-alternance ; et
- une phase d'établissement d'un arc ("Arc Tracking" en anglais). Cette dernière phase est une phase de décharge électrique d'intensité limitée se propageant le long des câbles qui, par carbonisation de gaines isolantes de câbles électriques, peut entraîner la destruction partielle ou totale d'un faisceau de câbles électriques.

Outre une détérioration de l'isolant d'un câble électrique, une connexion desserrée et une abrasion de câble sont également des terrains propices à l'apparition d'arcs électriques.

La présente invention a pour objet la détection d'un tel phénomène d'arc électrique de manière à pouvoir éviter les conséquences dommageables précitées.

On connaît des dispositifs de protection, appelés disjoncteurs thermiques, qui réalisent une protection dite en "sur courant". Toutefois, ces disjoncteurs thermiques usuels, qui protègent les câbles d'alimentation lorsque l'énergie consommée par la charge connectée excède sa valeur nominale, sont inadaptés à la protection vis-à-vis des phénomènes d'arc, en raison de l'intensité limitée à laquelle les phénomènes de décharge des arcs apparaissent et se propagent sur un réseau électrique, cette intensité limitée ne permettant pas de déclencher lesdits disjoncteurs thermiques.

Le document US2004/0156153 (Csanky et al.) divulgue la détection des signaux indicatifs de la présence d'un arc électrique sur un câble d'avion EP537066 (EDF) divulgue un procédé de détection d'un arc électrique basé sur une analyse vectorielle des données de mesure électriques.

La présente invention a pour objet de remédier à ces inconvénients. Elle concerne un procédé permettant de détecter au plus tôt, de façon particulièrement efficace, tout phénomène d'arc électrique sur au moins un câble électrique, faisant par exemple partie d'un faisceau de câbles électriques.

A cet effet, selon l'invention, ledit procédé est remarquable en ce que :

A/ dans une étape préliminaire, on détermine une base de données comprenant une pluralité de classes d'appartenance, dont une première classe relative à une phase d'effluves à détecter et au moins une seconde classe relative à des phénomènes susceptibles de perturber la détection ; et

B/ dans une étape ultérieure de détection, successivement :

a) dans une phase d'acquisition :

α) on réalise une mesure de courant électrique et une mesure de tension électrique directement sur ledit câble électrique ;

β) on filtre lesdites mesures de courant et de tension ainsi réalisées; et

γ) on numérise les mesures ainsi filtrées de manière à former deux segments de données numérisées, relatifs respectivement au courant électrique et à la tension électrique ; et

b) dans une phase de traitement suivante :

α) on soumet chacun desdits segments à une pluralité de fonctions particulières, engendrant chacune une grandeur scalaire, l'ensemble des grandeurs scalaires relatives au courant formant un premier vecteur et l'ensemble des grandeurs scalaires relatives à la tension formant un second vecteur;

β) à l'aide de ladite base de données et d'un vecteur de forme qui est obtenu à partir desdits premier et second vecteurs et qui est représentatif des mesures réalisées, on détermine la classe d'appartenance dudit vecteur de forme ; et

γ) on conclut:

- à l'existence d'un phénomène d'arc électrique, si ladite classe d'appartenance représente ladite première classe relative à une phase d'effluves ; et
- à une absence de phénomène d'arc électrique, sinon.

Ainsi, grâce à l'invention, on est en mesure de détecter de façon efficace tout phénomène d'arc électrique, apparaissant sur tout type de câble électrique ou de faisceau de câbles électriques, et notamment sur un câble ou un faisceau qui est monté sur un aéronef, par exemple sur un avion de transport.

De plus, grâce à la recherche d'une phase d'effluves, on est en mesure de détecter un phénomène d'arc électrique dès sa naissance (la phase d'effluves correspondant à la naissance du phénomène d'arc électrique, comme indiqué ci-dessus), ce qui permet de pouvoir prendre à temps toutes les mesures nécessaires pour empêcher l'établissement d'un arc ("Arc Tracking") et ses conséquences dommageables précitées.

On notera en outre que la protection obtenue grâce à l'invention peut être prévue conjointement à une protection thermique usuelle en "sur courant".

La phase d'effluves prise en compte dans la présente invention se caractérise par :

- une basse énergie ;
- une bande de hautes fréquences distinctes et indépendantes de la fréquence du réseau ;
- des amplitude, fréquence et périodicité aléatoires ; et
- une présence simultanée en tension et en courant.

La détection d'une phase d'effluves est complexe, notamment en raison de ses caractéristiques aléatoires. De plus, en environnement aéronautique, c'est-à-dire lorsque les câbles surveillés sont montés sur un aéronef, ils sont soumis à de nombreuses agressions extérieures électromagnétiques de forte intensité (foudre) et de faible intensité (couplage avec le champ d'un radar). Comme le phénomène d'effluves est de faible intensité, les agressions électromagnétiques pourraient dégrader la qualité et la fiabilité de la détection et engendrer des déclenchements intempestifs. De plus, chaque câble électrique alimente une charge non linéaire générant des distorsions et créant des harmoniques hautes fréquences (calculateur, phare, ...) qui pourraient également potentiellement polluer la détection. Toutefois, grâce à l'invention, on est en mesure de remédier à ces risques, en prenant en compte des classes d'appartenance relatives à des phénomènes (notamment les phénomènes électromagnétiques et les charges) qui sont susceptibles de perturber la détection, et en réalisant une discrimination entre les effluves recherchées et ces phénomènes perturbateurs.

Dans un mode de réalisation particulier :

- à l'étape B.a.$\alpha$, on réalise les mesures de courant et de tension de façon synchronisée, afin de préserver la relation de phase entre le courant et la tension ; et/ou
- à l'étape B.a.$\beta$, on réalise un filtrage passe-bande, afin d'éliminer l'information relative au réseau d'alimentation ; et/ou
- les fonctions particulières utilisées à l'étape B.b.$\alpha$ ont pour objet d'extraire les composantes principales du signal (vecteur de forme) interprétables pour la comparaison avec la base de données ; et/ou
- ledit vecteur de forme est obtenu par concaténation desdits premier et second vecteurs.

Dans un mode de réalisation préféré, à l'étape B.b.$\beta$, on détermine des probabilités d'appartenance dudit vecteur de forme respectivement aux différentes classes d'appartenance de ladite base de données, et à l'étape B.b.$\gamma$, on conclut à l'existence d'un phénomène d'arc électrique lorsqu'au moins la condition suivante est réalisée : la probabilité d'appartenance à ladite première classe est la plus élevée des différentes probabilités d'appartenance ainsi déterminées.

Dans ce cas, avantageusement, les probabilités d'appartenance sont déterminées à l'aide d'une décision Bayesienne.

En outre, de façon avantageuse, à l'étape B.b.$\gamma$, on conclut à l'existence d'un phénomène d'arc électrique, lorsque de plus les conditions suivantes sont également réalisées :

- la probabilité d'appartenance à ladite première classe est supérieure à un seuil d'ambiguïté ;
- la densité de probabilité est supérieure à une valeur prédéterminée ; et
- une distance de Mahalanobis est inférieure à une valeur prédéterminée.

De plus, avantageusement, à l'étape B.b.$\beta$ :

- on projette ledit vecteur de forme dans un sous-espace pour obtenir un point représentatif, présentant un nombre réduit de composantes principales ; et
- on projette ce point dans des espaces représentant les différentes classes d'appartenance de la base de données de manière à obtenir les probabilités d'appartenance correspondantes, de ce point qui est représentatif du vecteur de forme.

Par ailleurs, de façon avantageuse, ladite base de données est formée par apprentissage, à ladite étape préliminaire. Avantageusement, ladite base de données est formée à partir de mesures réalisées sur des câbles électriques présentant différents phénomènes, pour lesquels on désire constituer des classes d'appartenance, en mettant en oeuvre au moins lesdites étapes B.a.$\alpha$, B.a.$\beta$, B.a.$\gamma$ et B.b.$\alpha$ précitées.

La présente invention concerne également un dispositif de détection d'un phénomène d'arc électrique sur au moins un câble électrique faisant partie par exemple d'un faisceau de câbles électriques.

Selon l'invention, ledit dispositif est remarquable en ce qu'il comporte au moins :

- une base de données comprenant une pluralité de classes d'appartenance, dont une première classe relative à une phase d'effluves à détecter et au moins une seconde classe relative à des phénomènes susceptibles de perturber la détection;
- des premiers moyens pour réaliser une mesure de courant électrique et une mesure de tension électrique directement sur ledit câble électrique ;
- des deuxièmes moyens pour filtrer lesdites mesures de courant et de tension ;
- des troisièmes moyens pour numériser les mesures ainsi filtrées de manière à forme deux segments de données numérisées, relatifs respectivement au courant électrique et à la tension électrique ;
- des quatrièmes moyens pour soumettre chacun desdits segments à une pluralité de fonctions particulières, engendrant chacune une grandeur scalaire, l'ensemble des grandeurs scalaires relatives au courant formant un premier vecteur et l'ensemble des grandeurs scalaires relatives à la tension formant un second vecteur ;
- des cinquièmes moyens pour déterminer la classe d'appartenance d'un vecteur de forme, à l'aide de ladite base de données et dudit vecteur de forme qui est obtenu à partir desdits premier et second vecteurs et qui est représentatif des mesures réalisées par lesdits premiers moyens ; et
- des sixièmes moyens pour déduire l'existence ou non d'un phénomène d'arc électrique, à partir du résultat des traitements réalisés par lesdits cinquièmes moyens.

En outre, dans un mode de réalisation particulier, ledit dispositif comporte de plus:

- un moyen d'alimentation électrique qui est relié audit câble électrique surveillé et qui est alimenté électriquement par l'intermédiaire de ce dernier, ce qui évite d'avoir à prévoir une alimentation électrique spécifique pour le dispositif de détection ; et/ou
- un organe de commutation susceptible d'interrompre automatiquement le courant fourni par ledit câble électrique surveillé, en cas de détection d'un phénomène d'arc électrique. Le dispositif conforme à l'invention fonctionne ainsi comme disjoncteur.

Le dispositif conforme à l'invention présente de nombreux avantages. En particulier, il permet :

- de détecter en temps réel chaque phénomène d'arc qui apparaît sur tout type de câble électrique, et ceci dès la naissance de ce phénomène ;
- d'augmenter la fiabilité de la prise de décision, et donc de limiter la probabilité de fausses alarmes ;
- d'augmenter la sensibilité de détection vis-à-vis de l'arc électrique, et donc de préserver l'intégrité du réseau électrique ; et
- d'immuniser la protection vis-à-vis de phénomènes perturbateurs.

Les figures du dessin annexé feront bien comprendre comment l'invention peut être réalisée. Sur ces figures, des références identiques désignent des éléments semblables.

La figure 1 est le schéma synoptique d'un dispositif conforme à l'invention.

Les figures 2 et 3 montrent plus en détail de façon schématique des moyens de traitement particuliers d'un dispositif conforme à l'invention.

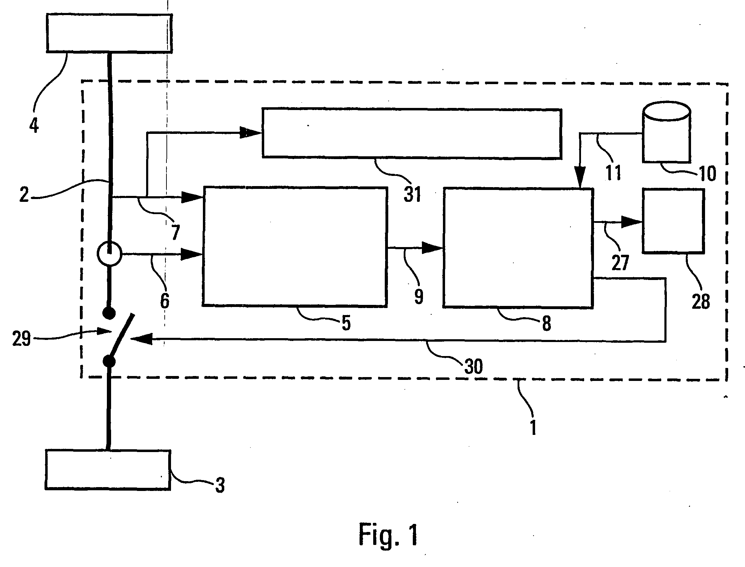

Le dispositif 1 conforme à l'invention et représenté schématiquement sur la figure 1 a pour objet de détecter tout phénomène d'arc électrique sur au moins un câble électrique 2 faisant partie par exemple d'un faisceau de câbles électriques, et ceci avant l'établissement définitif d'un arc électrique qui peut entraîner la destruction partielle ou totale d'un faisceau de câbles électriques, afin notamment:

- d'améliorer la sécurité;
- de limiter les conséquences d'une éventuelle décharge électrique ; et

- de préserver l'intégrité des câbles adjacents, ceci sans nuire à la disponibilité de l'aéronef lorsque le câble surveillé est monté sur un aéronef, en particulier un avion de transport. Dans ce dernier cas, le dispositif 1 est un dispositif embarqué.

De façon usuelle, ledit câble électrique 2 surveillé permet de relier une charge usuelle 3 à un générateur 4 de courant électrique.

Selon l'invention, ledit dispositif 1 comporte :

- une unité d'acquisition 5 qui est reliée par l'intermédiaire de liaisons 6 et 7 audit câble électrique 2 ;
- une unité de traitement d'informations 8 qui est reliée par l'intermédiaire d'une liaison 9 à ladite unité d'acquisition 5 ; et
- une base de données 10 qui est reliée par l'intermédiaire d'une liaison 11 à ladite unité de traitement d'informations 8. Cette base de données 10 comprend une pluralité de classes d'appartenance C1, C2, C3, dont une première classe C1 relative à une phase d'effluves (précisée ci-après) à détecter et des classes C2, C3 relatives à des phénomènes susceptibles de perturber la détection, en particulier une classe C2 d'agressions électromagnétiques de faible intensité (champs radar, ...) et une classe C3 de charges. Ladite base de données 10 est formée par apprentissage, lors d'une étape préliminaire, comme précisé ci-dessous.

La phase d'effluves prise en compte dans la présente invention se caractérise par :

- une basse énergie;
- une bande de hautes fréquences distinctes et indépendantes de la fréquence du réseau ;
- des amplitude, fréquence et périodicité aléatoires ; et
- une présence simultanée en tension et en courant.

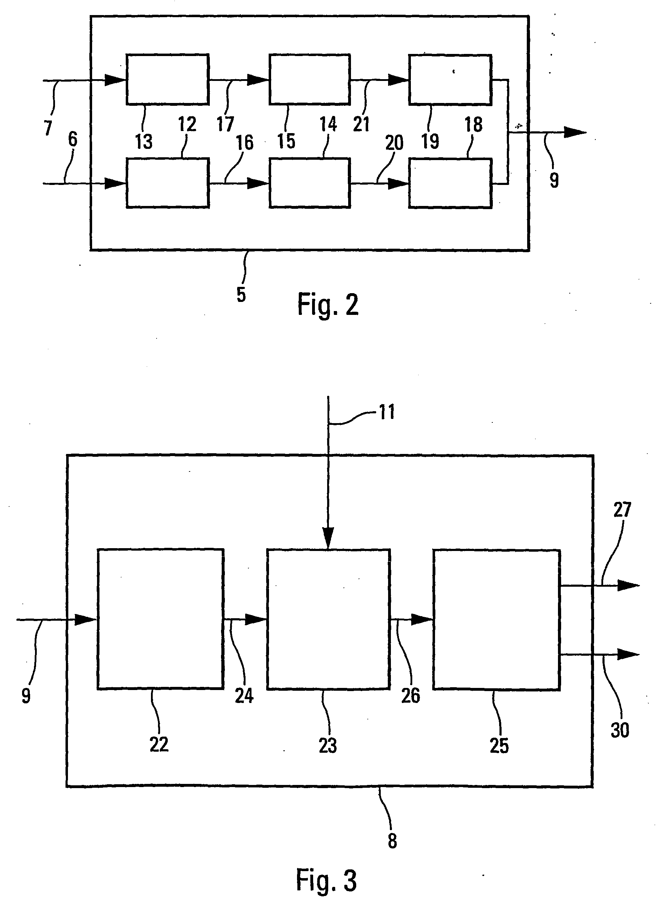

Comme représenté sur la figure 2, ladite unité d'acquisition 5 comporte selon l'invention :

- des moyens de mesure usuels 12 et 13 qui sont reliés auxdites liaisons 6 et 7, pour réaliser respectivement une mesure de courant électrique et une mesure de tension électrique directement sur ledit câble électrique 2 ;
- des moyens de filtrage 14 et 15 qui sont reliés par l'intermédiaire de liaisons 16 et 17 respectivement auxdits moyens de mesure 12 et 13 et qui sont destinés à filtrer lesdites mesures de courant et de tension ; et
- des moyens 18 et 19 qui sont reliés par l'intermédiaire de liaisons 20 et 21 respectivement auxdits moyens de filtrage 14 et 15 et qui sont destinés à numériser les mesures filtrées par lesdits moyens de filtrage 14 et 15 de manière à former deux segments de données numérisées, relatifs respectivement au courant électrique et à la tension électrique.

Dans un mode de réalisation particulier :

- lesdits moyens de mesure 12 et 13 réalisent les mesures de courant et de tension simultanément de façon synchronisée, afin de préserver l'information temporelle entre le courant et la tension. Un prélèvement de la tension et du courant est effectué avec un étage de mise en forme sur la phase qui est surveillée ; et
- lesdits moyens de filtrage 14 et 15 réalisent un filtrage passe-bande, par exemple par transformée de Fourier, afin d'éliminer l'information relative au réseau d'alimentation (générateur de courant 4). La fonction de filtrage permet d'extraire les composantes spectrales représentatives du phénomène à détecter.

Par ailleurs, comme représenté sur la figure 3, ladite unité de traitement d'informations 8 comporte, selon l'invention, au moins :

- des moyens 22 qui sont reliés à la liaison 9, qui comportent une pluralité de fonctions particulières intégrées et qui sont destinés à soumettre chacun desdits segments (de données numérisées) reçus desdits moyens 18 et 19 à ladite pluralité de fonctions particulières. Chacune desdites fonctions particulières fournit à la sortie une grandeur scalaire. L'ensemble des différentes grandeurs scalaires relatives au courant forme alors un premier vecteur, tandis que l'ensemble des grandeurs scalaires relatives à la tension forme un second vecteur. Lesdites fonctions particulières ont pour objet d'extraire les composantes principales du signal (vecteur de forme) interprétables pour la comparaison avec la base de données 10 ;
- des moyens 23 qui sont reliés par l'intermédiaire d'une liaison 24 auxdits moyens 22, pour déterminer la classe d'appartenance d'un vecteur de forme, à l'aide d'une part d'informations issues de ladite base de données 10 et reçues par l'intermédiaire de la liaison 11, et, d'autre part, dudit vecteur de forme qui est obtenu à partir desdits premier et second vecteurs et qui est représentatif des mesures réalisées par lesdits moyens de mesure 12 et 13 sur ledit câble électrique 2. Ce vecteur de forme est donc représentatif de l'état électrique dudit câble 2. Plus précisément, ledit vecteur de forme est obtenu par concaténation desdits premier et second vecteurs déterminés par les moyens 22 ; et

- des moyens 25 qui sont reliés par l'intermédiaire d'une liaison 26 auxdits moyens 23, pour déduire du résultat des traitements réalisés par lesdits moyens 23, l'existence ou non d'un phénomène d'arc électrique au niveau dudit câble électrique 2.

Plus précisément :

- lesdits moyens 23 déterminent des probabilités d'appartenance dudit vecteur de forme respectivement aux différentes classes d'appartenance C1, C2 et C3 de ladite base de données 10 ; et
- lesdits moyens 25 concluent à l'existence d'un phénomène d'arc électrique lorsqu'au moins la condition suivante est réalisée : la probabilité d'appartenance à ladite classe C1 (relative à la phase d'effluves) est la plus élevée des différentes probabilités d'appartenance déterminées par lesdits moyens 23.

Comme indiqué ci-dessus, les acquisitions numériques sont récupérées et traitées par segment. Le dispositif 1 dispose ainsi de deux segments périodiques de mesures (un sur le courant et un sur la tension). Ledit dispositif 1 détermine si une effluve ou phase d'effluves est présente à partir de la combinaison mathématique de ces deux segments. La démarche mathématique consiste à effectuer une classification sur les mesures de courant et de tension, pour la phase examinée. L'idée générale consiste à extraire le maximum d'informations du phénomène physique afin de pouvoir le caractériser à la fois en amplitude, fréquence et temps. A partir des segments de mesures, plusieurs algorithmes mathématiques permettent de disséquer le signal physique. Chaque algorithme possède sa propre fonction de transfert. La combinaison de tous ces résultats est utilisée pour une reconnaissance de forme, précisée ci-dessous et mise en oeuvre par les moyens 23.

Lesdits moyens 23 jouent le rôle d'un moyen de classification. A cet effet, ils disposent dudit vecteur de forme caractérisant la tension et le courant de la phase examinée, ainsi que de ladite base de données 10 représentant les phénomènes à rechercher. A partir du vecteur de forme, une projection vers un sous-espace est effectuée, afin de réduire le nombre de composantes principales de ce vecteur de forme. Le point aux coordonnées réduites obtenu est ensuite projeté dans des espaces de forme représentant lesdites classes d'appartenance C1, C2 et C3 de la base de données 10.

On notera qu'une analyse en composante principale (permettant de réduire le nombre de composantes) permet de calculer le degré de redondance entre variables décrivant le comportement d'un phénomène. Une telle analyse permet de passer d'un espace à "m" dimensions à un espace à "p" dimensions, avec "m" > "p". L'étude du degré de redondance entre variables permet de trier les composantes (variables) par ordre d'importance. A l'issue du traitement, l'analyse fournit une matrice de passage entre l'espace à "m" dimensions et l'espace à "p" dimensions. On dispose par exemple en entrée de l'analyse de six composantes (ou variables) décrivant les trois phénomènes précités (effluves, perturbations électromagnétiques, charges).

Lesdits moyens 23 déterminent les probabilités d'appartenance précités à l'aide d'une décision Bayesienne.

La décision Bayesienne s'appuie sur une loi normale de probabilité, c'est-à-dire que chaque classe est modélisée par une Gaussienne dont le point culminant (épicentre) correspond à la moyenne des vecteurs de forme. Le point de mesure qui est projeté dans le plan de la base de données fait l'objet des calculs suivants :

- la distance entre ce point de mesure et l'épicentre de la classe C1 ;
- la distance entre ce point de mesure et l'épicentre de la classe C2 ; et
- la distance entre ce point de mesure et l'épicentre de la classe C3.

Une telle mesure est appelée mesure de la distance de Mahalanobis. Une fois toutes les distances calculées, le théorème de Bayes est utilisé pour déterminer la probabilité a posteriori d'appartenance à chacune des différentes classes C1, C2 et C3. Seule la probabilité a posteriori maximale est finalement prise en compte.

Cette décision Bayesienne s'appuie sur les caractéristiques suivantes:

A/ calcul de la probabilité a posteriori de Bayes:

$$P(w_i / Z) = \frac{p(Z / w_i) \times Pr(w_i)}{\sum_{k=1}^{n} p(Z / w_k) \times Pr(w_k)}$$

avec :

- $w_1$ : la classe d'appartenance C1, C2, C3, i variant de 1 à $n$, $n$ étant égal à 3 dans l'exemple considéré;
- $Pr(w_i)$ : la probabilité a priori ; et
- $p(Z/w_i)$ : la densité de probabilité (pour la loi normale précitée) précisée ci-après;

B/ densité de probabilité d'une mesure :

$$p(Z / w_i) = \frac{1}{\sqrt{(2\pi)^d \times \det(\sigma_i)}} \, x e^{-\left(\frac{1}{2}(z-\mu_i)^T \sigma_i^{-1}(z-\mu_i)\right)}$$

avec :

- $T$ : un symbole qui indique que l'on prend en compte la transposée de la matrice ;
- $d$ : la dimension du vecteur d'entrée ;
- $\mu_i$ : le moment d'ordre 1 de la classe i {i = 1 à n} ;
- $\sigma_i$ : le moment d'ordre 2 de la classe i ;
- $w_i$ : la classe d'appartenance concernée C1, C2, C3 ; et
- $Z$ : le point de mesure issu d'une analyse en composante principale en quatre dimensions ;

C/ condition générale de Bayes :

$$\sum_{i=1}^{n} P(w_i / Z) = 1$$

Ainsi, en sortie, on obtient $n$ probabilités a posteriori, dont la somme est égale à 1.

Si un signal, qui n'appartient à aucune des classes C1, C2 et C3 considérées, est injecté en entrée, l'équation précédente faussera le calcul, puisque par définition la somme est égale à 1 et par conséquent, à ce signal, sera quand même attribuée une classe d'appartenance. Aussi, pour éviter un tel problème, les moyens 23 mettent de plus en oeuvre une stratégie de rejet. Cette stratégie de rejet permet d'affiner la décision, et donc les performances générales. La stratégie de rejet a pour but de fixer des frontières à l'espace de décision de la base de données 10 qui est par exemple en cinq dimensions. Cela revient à créer un volume d'appartenance autour de la classe C1 des effluves. Le théorème de Bayes fournit des probabilités a posteriori, dont seule la probabilité maximale est prise en compte. Si cette probabilité maximale correspond à ladite classe C1 (effluves), la stratégie de rejet est mise en oeuvre, car l'estimation peut être faussée.

Plus précisément, grâce à cette stratégie de rejet, pour que les moyens 23 attribuent à un vecteur de forme (représentatif des mesures réalisées sur le câble 2), la classe d'appartenance C1 des effluves, il faut que toutes les conditions suivantes soient vérifiées :

- la probabilité a posteriori fournie par le théorème de Bayes est maximale pour la classe C1 des effluves, soit $P(w_1/Z) > P(w_2/Z) > P(w_3/Z)$ ou $P(w_1/Z) > P(w_3/Z) > P(w_2/Z)$, en supposant que la classe C1 des effluves présente la probabilité $P(w_1/Z)$ ;
- cette dernière probabilité est supérieure à un seuil d'ambiguïté, à savoir 0,33 dans le cas de trois classes C1, C2 et C3 ;
- la densité de probabilité de la loi normale est supérieure à $2 \times 10^{-4}$; et
- la distance de Mahalanobis est inférieure à 0,26.

Lesdits moyens 23 réalisent de plus un seuillage sur la classe C1 des effluves. Si le point considéré appartient à l'espace (ou volume) correspondant aux critères d'appartenance à la classe C1, une décision appropriée est prise par les moyens 25. Cette décision peut prendre plusieurs formes, notamment en fonction du degré d'avancement du phénomène dans le temps.

Lesdits moyens 25 peuvent transmettre cette décision par l'intermédiaire d'une liaison 27 à un moyen d'information 28, par exemple un indicateur visuel (voyant) ou sonore ou un écran de visualisation, qui est susceptible d'informer un opérateur le cas échéant de la détection d'un phénomène d'arc.

Lesdits moyens 25 peuvent également commander automatiquement un interrupteur 29 par l'intermédiaire d'une liaison 30, pour interrompre automatiquement le courant fourni par ledit câble électrique 2 surveillé à ladite charge 3, en cas de détection d'un phénomène d'arc électrique au niveau dudit câble électrique 2.

Ledit dispositif 1 comporte, de plus, un moyen d'alimentation électrique 31 qui est relié par la liaison 7 audit câble électrique 2 surveillé et qui est alimenté électriquement par l'intermédiaire de ce dernier. Le dispositif 1 est donc alimenté électriquement directement par l'intermédiaire du câble électrique 2 surveillé.

Par ailleurs, on notera que ladite base de données 10 est formée par apprentissage, à partir de mesures réalisées sur des câbles électriques présentant différents phénomènes, pour lesquels on désire constituer des classes d'appartenance, en mettant en oeuvre au moins les fonctions précitées de l'unité d'acquisition 5 et des moyens 22 et 23.

Pour constituer ladite base de données 10, des enregistrements sont effectués en laboratoire afin de disposer d'un ensemble de mesures suffisamment représentatif des différentes classes C1, C2 et C3 considérées. Les enregistrements subissent le même traitement mathématique que les futures mesures (précisées ci-dessus), pour lesquelles on utilisera cette base de données 10.

Le dispositif 1 conforme à l'invention utilise un mécanisme de classification et de rejet basé sur une statistique du signal qui permet de discriminer le phénomène d'arc électrique de perturbations externes. Ce dispositif 1 présente de nombreux avantages. En particulier, il permet :

- de détecter en temps réel chaque phénomène d'arc qui apparaît sur tout type de câble électrique 2, et ceci dès la naissance d'un tel phénomène ;
- d'éviter toute confusion entre effluves et consommation normale d'une charge ;
- d'augmenter la fiabilité de la prise de décision, et donc de limiter la probabilité de fausses alarmes ;
- d'augmenter la sensibilité de détection vis-à-vis d'un arc électrique, et donc de préserver l'intégrité du réseau électrique ; et
- d'immuniser la protection vis-à-vis de phénomènes perturbateurs.

De plus, ledit dispositif 1 fonctionne pour des réseaux électriques continus ou alternatifs, indépendamment de la fréquence de ces réseaux électriques. Ledit dispositif 1 est également indépendant du type de charge connectée sur le réseau surveillé.

**Revendications**

1.  Procédé de détection d'un phénomène d'arc électrique sur au moins un câble électrique (2),
    **caractérisé en ce que** :

    A/ dans une étape préliminaire, on détermine une base de données (10) comprenant une pluralité de classes d'appartenance, dont une première classe relative à une phase d'effluves à détecter et au moins une seconde classe relative à des phénomènes susceptibles de perturber la détection ; et
    B/ dans une étape ultérieure de détection, successivement :

    a) dans une phase d'acquisition :

    α) on réalise une mesure de courant électrique et une mesure de tension électrique directement sur ledit câble électrique (2) ;
    β) on filtre lesdites mesures de courant et de tension ainsi réalisées ; et
    γ) on numérise les mesures ainsi filtrées de manière à former deux segments de données numérisées, relatifs respectivement au courant électrique et à la tension électrique ; et

    b) dans une phase de traitement suivante :

    α) on soumet chacun desdits segments à une pluralité de fonctions particulières, engendrant chacune une grandeur scalaire, i'ensemble des grandeurs scalaires relatives au courant formant un premier vecteur et l'ensemble des grandeurs scalaires relatives à la tension formant un second vecteur ;

β) à l'aide de ladite base de données (10) et d'un vecteur de forme qui est obtenu à partir desdits premier et second vecteurs et qui est représentatif des mesures réalisées, on détermine la classe d'appartenance dudit vecteur de forme ; et

γ) on conclut :

- à l'existence d'un phénomène d'arc électrique, si ladite classe d'appartenance représente ladite première classe relative à une phase d'effluves ; et
- à une absence de phénomène d'arc électrique, sinon.

2. Procédé selon la revendication 1,
   **caractérisé en ce qu'**à l'étape B.a.α, on réalise les mesures de courant et de tension de façon synchronisée.

3. Procédé selon l'une des revendications 1 et 2,
   **caractérisé en ce qu'**à l'étape B.a.β, on réalise un filtrage passe-bande.

4. Procédé selon l'une des revendications précédentes,
   **caractérisé en ce que** les fonctions particulières utilisées à l'étape B.b.α ont pour objet d'extraire les composantes principales du signal, interprétables pour la comparaison avec ladite base de données (10).

5. Procédé selon l'une quelconque des revendications précédentes,
   **caractérisé en ce que** ledit vecteur de forme est obtenu par concaténation desdits premier et second vecteurs.

6. Procédé selon l'une quelconque des revendications précédentes,
   **caractérisé en ce qu'**à l'étape B.b.β, on détermine des probabilités d'appartenance dudit vecteur de forme respectivement aux différentes classes d'appartenance de ladite base de données (10), et à l'étape B.b.γ, on conclut à l'existence d'un phénomène d'arc électrique lorsqu'au moins la condition suivante est réalisée : la probabilité d'appartenance à ladite première classe est la plus élevée des différentes probabilités d'appartenance ainsi déterminées.

7. Procédé selon la revendication 6,
   **caractérisé en ce que** les probabilités d'appartenance sont déterminées à l'aide d'une décision Bayesienne.

8. Procédé selon l'une des revendications 6 et 7,
   **caractérisé en ce qu'**à l'étape B.b.γ, on conclut à l'existence d'un phénomène d'arc électrique, lorsque de plus les conditions suivantes sont également réalisées :

   - la probabilité d'appartenance à ladite première classe est supérieure à un seuil d'ambiguïté ;
   - une densité de probabilité est supérieure à une valeur prédéterminée ; et
   - une distance de Mahalanobis est inférieure à une valeur prédéterminée.

9. Procédé selon l'une quelconque des revendications 6 à 8,
   **caractérisé en ce qu'**à l'étape B.b.β :

   - on projette ledit vecteur de forme dans un sous-espace pour obtenir un point représentatif, présentant un nombre réduit de composantes principales ; et
   - on projette ce point dans des espaces représentant les différentes classes d'appartenance de la base de données (10) de manière à obtenir les probabilités d'appartenance correspondantes, de ce point qui est représentatif du vecteur de forme.

10. Procédé selon l'une quelconque des revendications précédentes,
    **caractérisé en ce que** ladite base de données (10) est formée par apprentissage, à ladite étape préliminaire.

11. Procédé selon la revendication 10,
    **caractérisé en ce que** ladite base de données (10) est formée à partir de mesures réalisées sur des câbles électriques présentant différents phénomènes, pour lesquels on désire constituer des classes d'appartenance, en mettant en oeuvre au moins lesdites étapes B.a.α, B.a.β, B.a.γ et B.b.α.

**12.** Dispositif de détection d'un phénomène d'arc électrique sur au moins un câble électrique (2),
**caractérisé en ce qu'**il comporte au moins :

- une base de données (10) comprenant une pluralité de classes d'appartenance, dont une première classe relative à une phase d'effluves à détecter et au moins une seconde classe relative à des phénomènes susceptibles de perturber la détection ;
- des premiers moyens (12, 13) pour réaliser une mesure de courant électrique et une mesure de tension électrique directement sur ledit câble électrique (2) ;
- des deuxièmes moyens (14, 15) pour filtrer lesdites mesures de courant et de tension ;
- des troisièmes moyens (18, 19) pour numériser les mesures ainsi filtrées de manière à former deux segments de données numérisées, relatifs respectivement au courant électrique et à la tension électrique ;
- des quatrièmes moyens (22) pour soumettre chacun desdits segments à une pluralité de fonctions particulières, engendrant chacune une grandeur scalaire, l'ensemble des grandeurs scalaires relatives au courant formant un premier vecteur et l'ensemble des grandeurs scalaires relatives à la tension formant un second vecteur;
- des cinquièmes moyens (23) pour déterminer la classe d'appartenance d'un vecteur de forme, à l'aide de ladite base de données (10) et dudit vecteur de forme qui est obtenu à partir desdits premier et second vecteurs et qui est représentatif des mesures réalisées par lesdits premiers moyens (12, 13) ; et
- des moyens (25) pour déduire l'existence ou non d'un phénomène d'arc électrique, à partir du résultat des traitements réalisés par lesdits cinquièmes moyens (23).

**13.** Dispositif selon la revendication 12,
**caractérisé en ce qu'**il comporte, de plus, un moyen d'alimentation électrique (31) qui est relié audit câble électrique (2) surveillé et qui est alimenté électriquement par l'intermédiaire de ce dernier.

**14.** Dispositif selon l'une des revendications 12 et 13,
**caractérisé en ce qu'**il comporte, de plus, un organe de commutation (29) susceptible d'interrompre automatiquement le courant fourni par ledit câble électrique (2) surveillé, en cas de détection d'un phénomène d'arc électrique.

**Claims**

**1.** A method of detecting an electrical arcing phenomenon on at least one electrical cable (2),
**characterized in that**:

A/ in a preliminary step, there is determined a database (10) comprising a plurality of classes, including a first class relating to a corona discharge phase to be detected and at least one second class relating to phenomena liable to interfere with the detection process; and
B/ in a subsequent detection step, successively:

a) in an acquisition phase:

α) an electrical current measurement and an electrical voltage measurement are carried out directly on said electrical cable (2);

β) said current and voltage measurements obtained in this way are filtered; and
γ) the measurements filtered in this way are digitized to form two digitized data segments relating to the electrical current and to the electrical voltage, respectively; and

b) in a subsequent processing phase:

α) each of said segments is subjected to a plurality of particular functions each generating a scalar magnitude, the set of scalar magnitudes relating to the current forming a first vector and the set of scalar magnitudes relating to the voltage forming a second vector;
β) using said database (10) and a shape vector obtained from said first and second vectors that is representative of the measurements carried out, the class to which said shape vector belongs is determined; and
γ) it is concluded that:

• an electrical arcing phenomenon exists if said class represents said first class relating to a corona discharge phase; and
• there is no electrical arcing phenomenon otherwise.

2. The method as claimed in claim 1,
**characterized in that** in the step B.a.$\alpha$ the current and voltage measurements are carried out in a synchronized fashion.

3. The method as claimed in either claim 1 or claim 2,
**characterized in that** in the step B.a.$\beta$ band-pass filtering is effected.

4. The method as claimed in any one of the preceding claims,
**characterized in that** the particular functions used in the step B.b.$\alpha$ have the object of extracting interpretable main components of the signal for comparison with said database (10).

5. The method as claimed in any one of the preceding claims,
**characterized in that** said shape vector is obtained by concatenation of said first and second vectors.

6. The method as claimed in any one of the preceding claims,
**characterized in that** in the step B.b.$\beta$ there are determined probabilities of said shape vector belonging to respective classes of said database (10) and in the step B.b.$\gamma$ it is concluded that an electrical arcing phenomenon exists if at least the following condition is satisfied: the probability of belonging to said first class is higher than the probabilities thus determined.

7. The method as claimed in claim 6,
**characterized in that** the probabilities are determined with the aid of a Bayesian decision.

8. The method as claimed in either claim 6 or claim 7,
**characterized in that** in the step B.b.$\gamma$ it is concluded that an electrical arcing phenomenon exists if the following conditions are also satisfied:

- the probability of belonging to said first class is above an ambiguity threshold;
- a probability density is greater than a predetermined value; and
- a Mahalanobis distance is less than a predetermined value.

9. The method as claimed in any one of claims 6 to 8,
**characterized in that** in the step B.b.p:

- said shape vector is projected into a sub-space to obtain a representative point having a reduced number of main components; and
- this point is projected into spaces representing the classes of the database (10) to obtain the corresponding probabilities of this point belonging to said classes that is representative of the shape vector.

10. The method as claimed in any one of the preceding claims,
**characterized in that** said database (10) is formed by a training process in said preliminary step.

11. The method as claimed in claim 10,
**characterized in that** said database (10) is formed from measurements carried out on electrical cables subject to phenomena for which it is required to constitute classes by implementation of at least said steps B.a.$\alpha$, B.a.$\beta$, B.a.$\gamma$ and B.b.$\alpha$.

12. A device for detecting an electrical arcing phenomenon on at least one electrical cable (2),
**characterized in that** it includes at least:

- a database (10) comprising a plurality of classes including a first class relating to a corona discharge phase to be detected and at least one second class relating to phenomena liable to interfere with the detection process,
- first means (12, 13) for carrying out an electrical current measurement and an electrical voltage measurement directly on said electrical cable (2);

- second means (14, 15) for filtering said current and voltage measurements;
- third means (18, 19) for digitizing the filtered measurements to form two digitized data segments relating to the electrical current and to the electrical voltage, respectively;
- fourth means (22) for subjecting each of said segments to a plurality of particular functions each generating a scalar magnitude, the set of scalar magnitudes relating to the current forming a first vector and the set of scalar magnitudes relating to the voltage forming a second vector;
- fifth means (23) for determining the class to which a shape vector obtained from said first and second vectors and representative of the measurements carried out by said first means (12, 13) belongs using said database (10); and
- means (25) for deducing the existence or non-existence of an electrical arcing phenomenon from the result of the processing carried out by said fifth means (23).

13. The device as claimed in claim 12,
**characterized in that** it further includes electrical power supply means (31) connected to said electrical cable (2) that is being monitored and supplied with electrical power thereby.

14. The device as claimed in either claim 12 or claim 13,
**characterized in that** it further includes a switching unit (29) adapted to interrupt the current supplied by said electrical cable (2) that is being monitored automatically in the event of detection of an electrical arcing phenomenon.

**Patentansprüche**

1. Verfahren zur Erkennung eines elektrischen Bogenphänomens auf mindestenseinem elektrischen Kabel (2), **dadurch gekennzeichnet, dass**:

A/ in einem vorgelagerten Schritt eine Datenbasis (10) festgelegt wird, die eine Vielzahl von Zugehörigkeitsklassen umfasst, von denen eine erste Klasse auf eine zu erkennende Glimmentladungsphase bezogen ist und mindestens eine zweite Klasse auf Phänomene bezogen ist, die geeignet sind, die Erkennung zu stören und
B/ in einem nachfolgenden Detektionsschritt nacheinander:

a) in einer Erfassungsphase:

$\alpha$) eine elektrische Strommessung und eine elektrische Spannungsmessung direkt an dem elektrischen Kabel (2) durchgeführt werden,
$\beta$) die auf diese Weise vorgenommenen Strom- und Spannungsmessungen gefiltert werden und
$\gamma$) die auf diese Weise gefilterten Messungen so digitalisiert werden, dass sie zwei Segmente digitalisierter Daten bilden, die sich auf den elektrischen Strom bzw. auf die elektrische Spannung beziehen und

b) in einer anschließenden Behandlungsphase:

$\alpha$) jedes der Segmente einer Vielzahl von speziellen Funktionen unterzogen wird, die jeweils eine skalare Größe erzeugen, wobei der Satz von auf den Strom bezogenen skalaren Größen einen ersten Vektor bildet und der Satz von auf die Spannung bezogenen skalaren Größen einen zweiten Vektor bildet,
$\beta$) mithilfe der Datenbasis (10) und eines Formvektors, der aus dem ersten und dem zweiten Vektor gewonnen wird und der für die vorgenommenen Messungen repräsentativ ist, die Zugehörigkeitsklasse des Formvektors bestimmt wird und
$\gamma$) geschlossen wird auf

• das Vorhandensein eines elektrischen Bogenphänomens, wenn die Zugehörigkeitsklasse die erste auf eine Glimmentladungsphase bezogene Klasse repräsentiert und
• das Nichtvorhandensein des Bogenphänomens, wenn nicht.

2. Verfahren nach Anspruch 1,
**dadurch gekennzeichnet, dass** in Schritt B.a.$\alpha$ die Strom- und Spannungsmessungen synchron durchgeführt werden.

**3.** Verfahren nach Anspruch 1 oder 2,
**dadurch gekennzeichnet, dass** in Schritt B.a.$\beta$ eine-Bandpassfilterung durchgeführt wird.

**4.** Verfahren nach einem der vorhergehenden Ansprüche,
**dadurch gekennzeichnet, dass** die in Schritt B.b.$\alpha$ verwendeten speziellen Funktionen die Aufgabe haben, die für den Vergleich mit der Datenbasis (10) auswertbaren Hauptkomponenten des Signals zu extrahieren.

**5.** Verfahren nach einem der vorhergehenden Ansprüche,
**dadurch gekennzeichnet, dass** der Formvektor durch Verkettung des ersten und zweiten Vektors gewonnen wird.

**6.** Verfahren nach einem der vorhergehenden Ansprüche,
**dadurch gekennzeichnet, dass** in Schritt B.b.$\beta$ Wahrscheinlichkeiten der Zugehörigkeit des Formvektors zu den jeweiligen unterschiedlichen Zugehörigkeitsklassen der Datenbasis (10) bestimmt werden und in Schritt B.b.$\gamma$ auf das Vorhandensein eines elektrischen Bogenphänomens geschlossen wird, wenn mindestens die folgende Bedingung erfüllt ist: die Wahrscheinlichkeit der Zugehörigkeit zu der ersten Klasse ist die höchste der auf diese Weise bestimmten Zugehörigkeitswahrscheinlichkeiten.

**7.** Verfahren nach Anspruch 6,
**dadurch gekennzeichnet, dass** die Zugehörigkeitswahrscheinlichkeiten mithilfe einer Bayes'schen Entscheidung bestimmt werden.

**8.** Verfahren nach Anspruch 6 oder 7,
**dadurch gekennzeichnet, dass** in Schritt B.b.$\gamma$ auf das Vorhandensein eines elektrischen Bogenphänomens geschlossen wird, wenn zusätzlich auch die folgenden Bedingungen erfüllt sind:

- die Wahrscheinlichkeit der Zugehörigkeit zur ersten Klasse ist höher als ein Mehrdeutigkeitsschwellenwert;
- eine Wahrscheinlichkeitsdichte ist höher als ein vorgegebener Wert und
- eine Mahalanobis-Distanz ist kleiner als ein vorgegebener Wert.

**9.** Verfahren nach einem der Ansprüche 6 bis 8,
**dadurch gekennzeichnet, dass** in Schritt B.b.$\beta$ :

- der Formvektor in einen Unterraum projiziert wird, um einen repräsentativen Punkt zu erhalten, der eine reduzierte Anzahl von Hauptkomponenten aufweist und
- dieser Punkt in Räume projiziert wird, die die unterschiedlichen Zugehörigkeitsklassen der Datenbasis (10) repräsentieren, um die entsprechenden Zugehörigkeitswahrscheinlichkeiten dieses für den Formvektor repräsentativen Punktes zu erhalten.

**10.** Verfahren nach einem der vorhergehenden Ansprüche,
**dadurch gekennzeichnet, dass** die Datenbasis (10) in dem vorgelagerten Schritt durch Erlernen gebildet wird.

**11.** Verfahren nach Anspruch 10,
**dadurch gekennzeichnet, dass** die Datenbasis (10) aus Messungen gebildet wird, die an elektrischen Kabeln vorgenommenen werden, welche verschiedene Phänomene aufweisen, für die durch Ausführen zumindest der Schritte B.a.$\alpha$, B.a.$\beta$, B.a.$\gamma$ und B.b.$\alpha$. Zugehörigkeitsklassen gebildet werden sollen.

**12.** Einrichtung zur Erkennung eines elektrischen Bogenphänomens auf mindestens einem elektrischen Kabel (2),
**dadurch gekennzeichnet, dass** sie zumindest Folgendes aufweist:

- eine Datenbasis (10), die eine Vielzahl von Zugehörigkeitsklassen umfasst, von denen eine erste Klasse auf eine zu erkennende Glimmentladungsphase bezogen ist und mindestens eine zweite Klasse auf Phänomene bezogen ist, die geeignet sind, die Erkennung zu stören;
- erste Mittel (12, 13), um direkt an dem elektrischen Kabel (2) eine elektrische Strommessung und eine elektrische Spannungsmessung durchzuführen;
- zweite Mittel (14, 15) zum Filtern der Strom- und Spannungsmessungen;
- dritte Mittel (18, 19), um die auf diese Weise gefilterten Messungen derart zu digitalisieren, dass sie zwei Segmente digitalisierter Daten bilden, die sich auf den elektrischen Strom bzw. auf die elektrische Spannung beziehen;

- vierte Mittel (22), um jedes der Segmente einer Vielzahl von speziellen Funktionen zu unterziehen, die jeweils eine skalare Größe erzeugen, wobei der Satz von auf den Strom bezogenen skalaren Größen einen ersten Vektor bildet und der Satz von auf die Spannung bezogenen skalaren Größen einen zweiten Vektor bildet;
- fünfte Mittel (23) zum Bestimmen der Zugehörigkeitsklasse eines Formvektors mithilfe der Datenbasis (10) und des Formvektors, der aus dem ersten und dem zweiten Vektor gewonnen wird und der für die von den ersten Mitteln (12, 13) vorgenommenen Messungen repräsentativ ist und
- Mittel (25), um aus dem Ergebnis der von den fünften Mitteln (23) vorgenommenen Behandlung auf das Vorhandensein oder Nichtvorhandensein eines elektrischen Bogenphänomens zu schließen.

**13.** Einrichtung nach Anspruch 12,
**dadurch gekennzeichnet, dass** sie außerdem ein elektrisches Versorgungsmittel (31) umfasst, das mit dem überwachten elektrischen Kabel (2) verbunden ist und das über Letzteres elektrisch versorgt wird.

**14.** Einrichtung nach Anspruch 12 oder 13,
**dadurch gekennzeichnet, dass** sie außerdem ein Schaltorgan (29) umfasst, das geeignet ist, im Falle einer Detektion eines elektrischen Bogenphänomens den von dem überwachten elektrischen Kabel (2) gelieferten Strom automatisch zu unterbrechen.

Fig. 1

EP 1 815 260 B1

Fig. 2

Fig. 3

**RÉFÉRENCES CITÉES DANS LA DESCRIPTION**

**Documents brevets cités dans la description**

- US 20040156153 A, Csanky
- EP 537066 A